# FASCICULE DE BREVET EUROPEEN

(11) **EP 3 188 367 B1**
(45) Date de publication et mention de la délivrance du brevet: **19.06.2019**
(21) Numéro de dépôt: 16020513.4
(22) Date de dépôt: 23.12.2016
(51) Int. Cl.: H03H 9/00, H03H 9/02

(54) **PERFECTIONNEMENT AUX TRANSDUCTEURS À ONDES DE VOLUME GUIDÉES EN SURFACE**
VERBESSERUNG VON WANDLERN MIT AN DER OBERFLÄCHE GEFÜHRTEN VOLUMENWELLEN
IMPROVEMENT TO SURFACE-GUIDED VOLUME WAVE TRANSDUCERS

(30) Priorité: 28.12.2015 FR 1563360
(43) Date de publication de la demande: 05.07.2017
(73) Titulaire: FREC|N|SYS, 25000 Besançon (FR); CNRS Centre National de la Recherche Scientifique, 75016 Paris (FR)
(72) Inventeur: Ballandras, Sylvain, F25000 Besançon (FR); Bartasyte, Ausrine, F25000 Besançon (FR); Salut, Roland, 39700 Fraisans (FR)
(74) Mandataire: Grünecker Patent- und Rechtsanwälte PartG mbB

(56) Documents cités:
- WO-A1-2010/077313
- FR-A1- 2 997 027
- US-A1- 2008 246 559
- US-B1- 7 898 158
- US-B1- 8 525 619

## Description

### Domaine technique et état de l'art

L'invention concerne un transducteur à ondes de volume guidées en surface par des structures d'excitation synchrone de l'onde élastique guidée, et plus particulièrement un transducteur du type comprenant, sur une plaque de substrat acoustique, un réseau de sources d'excitation acoustique synchrones comprenant un premier peigne et un deuxième peigne comprenant chacun une pluralité de transducteurs élémentaires, les transducteurs élémentaires des deux peignes étant interdigités et rangés selon une direction X de propagation des ondes volumétriques guidées, chaque transducteur élémentaire s'étendant selon un axe transversal Y.

Un tel transducteur est notamment décrit en détail dans le document D1 = FR 2 997 027 en relation avec le document D2 = Standard IEEE - Std - 176 (révision 1949). Un tel transducteur permet de convertir un signal électrique ayant une fréquence de travail ft, ft correspondant à une longueur d'onde acoustique l pour laquelle le transducteur est dimensionné, en une onde de volume guidée en surface du substrat et réciproquement. Les transducteurs élémentaires d'un transducteur selon D1 sont réalisés sur un substrat isolant recouvert d'un plan de masse en matériau conducteur ; ils comprennent chacun un barreau en matériau piézoélectrique recouvert d'une électrode supérieure conductrice, le plan de masse formant une électrode inférieure commune à tous les transducteurs ; les électrodes supérieures de deux transducteurs élémentaires adjacents doivent être alimentées par des potentiels opposés +V, - V, le plan de masse formant une référence électrique, pour permettre le déplacement des ondes de volume.

Le principe fondamental d'un transducteur selon D1 combine un mode de volume, essentiellement polarisé longitudinalement, excité au sein de résonateurs distribués périodiquement à la surface du substrat, couplant ainsi l'énergie acoustique avec l'onde de surface du dit substrat. Ce principe permet une excitation efficace de l'onde par le matériau piézoélectrique déposé sur le substrat recouvert du plan de masse, et permet d'obtenir des coefficients de couplage acoustique bien supérieurs à ceux susceptibles d'être obtenus dans un transducteur réalisé selon une technologie antérieure.

Toutefois, l'expérience montre que, dans un transducteur conforme à l'enseignement de D1, l'obtention d'un bon couplage acoustique n'est possible qu'avec une source de tension différentielle, c'est à dire une source produisant deux potentiels d'excitation opposés par rapport à une référence de masse commune. Or, notamment pour la réalisation d'un capteur où l'énergie électrique est fournie par une antenne, comme c'est le cas par exemple d'un capteur embarqué, il est nécessaire d'utiliser un transformateur à point milieu, positionné entre l'antenne et le capteur, pour réaliser une source de tension différentielle apte à alimenter le transducteur.

Si l'utilisation d'un tel transformateur est envisageable pour des applications à température ambiante, inférieure à 50°C, cela n'est pas envisageable pour des applications à haute température de fonctionnement supérieures à 200°C, où il est indispensable de minimiser la connectique pour simplifier le circuit final et où le transformateur se révèle incapable d'effectuer sa fonction de conversion des signaux référencés en signaux différentiels.

### Description de l'invention

L'invention vise à perfectionner le transducteur de D1, d'une part pour faciliter son industrialisation et d'autre part pour rendre possible certaines utilisations d'un tel transducteur, notamment à hautes températures.

A cet effet, l'invention propose un nouveau transducteur à ondes de volume guidées, comprenant un substrat acoustique réalisé sous la forme d'une plaque formant une première couche en un premier matériau électriquement isolant, et un réseau de sources d'excitation acoustique synchrones, le réseau comportant un premier peigne et un deuxième peigne comprenant chacun une pluralité de transducteurs élémentaires, les transducteurs élémentaires du premier et du deuxième peignes étant interdigités, rangés selon une direction (X) de propagation des ondes volumétriques guidées et s'étendant chacun selon un axe transversal (Y).

Le transducteur selon l'invention est caractérisé en ce que chaque transducteur élémentaire comprend une électrode inférieure conductrice positionnée sur le substrat, l'électrode inférieure d'un transducteur élémentaire étant distincte de l'électrode inférieure des transducteurs élémentaires adjacents, un barreau en matériau piézoélectrique positionné sur l'électrode inférieure et une électrode supérieure conductrice positionnée sur le barreau, l'électrode supérieure d'un transducteur élémentaire étant distincte de l'électrode supérieure des transducteurs élémentaires adjacents.

Chaque transducteur élémentaire possédant sa propre électrode inférieure, il devient possible d'alimenter le transducteur par une source de tension référencée, produisant un unique potentiel d'excitation par rapport à une masse, tout en obtenant un bon coefficient de couplage acoustique. Ainsi, il n'est plus nécessaire d'utiliser un transformateur à point milieu pour réaliser une source différentielle. La connexion pour l'alimentation électrique d'un transducteur selon l'invention est ainsi largement simplifiée.

Selon un premier mode de réalisation de l'invention, l'électrode inférieure d'un transducteur élémentaire est reliée électriquement à l'électrode supérieure du transducteur élémentaire précédent et à l'électrode supérieure du transducteur élémentaire suivant et l'électrode supérieure d'un transducteur élémentaire est reliée électriquement à l'électrode inférieure du transducteur élémentaire précédent et à l'électrode inférieure du transducteur élémentaire suivant. Ainsi deux transducteurs élémentaires adjacents sont connectés tête-bêche de sorte que la différence de potentiel entre les électrodes d'un transducteur élémentaire est automatiquement inverse de la différence de potentiel entre les électrodes d'un transducteur élémentaire précédent ou les électrodes d'un transducteur élémentaire suivant. En d'autres termes, d'un point de vue fonctionnel, dans un transducteur selon l'invention, du fait des connexions originales des transducteurs élémentaires, les potentiels d'excitation des transducteurs élémentaires sont alternés pour deux transducteurs élémentaires adjacents, comme c'est le cas pour un transducteur selon D1. Par contre, et contrairement
à D1, une source de tension référencée est suffisante pour alimenter un transducteur selon l'invention puisqu'un seul potentiel autre que la masse est nécessaire.

Selon un deuxième mode de réalisation de l'invention, les électrodes inférieures de tous les transducteurs élémentaires sont agencées pour être connectées ensemble à une première borne d'une source d'alimentation, dans lequel les électrodes supérieures de tous les transducteurs élémentaires sont agencées pour être connectées ensemble à une deuxième borne de la source d'alimentation, la première borne et la deuxième borne étant respectivement une borne de potentiel et une masse ou l'inverse, et dans lequel le barreau de chaque transducteur élémentaire du premier peigne a une polarisation piézoélectrique opposée à la polarisation du barreau de chaque transducteur élémentaire du deuxième peigne. Ainsi, dans ce mode de réalisation, les transducteurs élémentaires sont connectés électriquement en série mais, du fait de la polarité alternée de leurs barreaux, les potentiels d'excitation des transducteurs élémentaires sont alternés pour deux transducteurs élémentaires adjacents, comme c'est le cas pour un transducteurs selon D1. Par contre, comme dans le mode de réalisation précédent de l'invention, la connexion des transducteurs élémentaires est simplifiée en ce qu'elle ne nécessite pas d'alimentation par une source de tension différentielle. De préférence, les barreaux des transducteurs élémentaires du premier et du deuxième peignes sont réalisés en un matériau piézoélectrique présentant des propriétés ferromagnétiques tel que le niobate de lithium (LiNbO₃), le tantalate de lithium (LiTaO₃), le niobate de potassium (KNbO₃) ou encore les céramiques de type PZT ou relaxeurs. La différence de polarisation piézoélectrique peut alors être obtenue par polarisation forcée des barreaux, par exemple selon le procédé décrit plus loin.

Dans ce deuxième mode en réalisation, toutes les électrodes inférieures des transducteurs élémentaires étant reliées entre elles, et connectées par exemple à la masse de la source de tension électrique, il est également possible de remplacer les électrodes inférieures par une couche conductrice recouvrant le substrat et formant une électrode inférieure commune à tous les transducteurs élémentaires et électriquement équivalente à l'ensemble des électrodes inférieures de tous les transducteurs élémentaires, les barreaux étant positionnés sur la couche conductrice formant électrode inférieure commune. Les barreaux étant ici polarisés en alternance, les polarités d'excitation des transducteurs élémentaires sont alternées pour deux transducteurs adjacents.

L'invention concerne également des procédés de fabrication de transducteurs selon l'invention, procédés détaillés dans la description ci-dessous.

L'invention concerne également tout dispositif comprenant un transducteur tel que décrit ci-dessus, notamment :
- un dispositif comprenant un transducteur connecté à une antenne radio-fréquence adaptée pour exciter et / ou détecter les ondes élastiques émises et / ou reçues par le transducteur sans fil, par exemple un dispositif sans contact tel qu'une étiquette électronique, un capteur embarqué, ...
- un filtre de fréquences à entrée / sortie différentielles comprenant un transducteur.

### Brève description des figures

L'invention sera mieux comprise, et d'autres caractéristiques et avantages de l'invention apparaîtront à la lumière de la description qui suit d'exemples de transducteurs selon l'invention. Ces exemples sont donnés à titre non limitatif. La description est à lire en relation avec les dessins annexés dans lesquels
- la figure 1 est une coupe transversale d'un transducteur selon un premier mode de mise en oeuvre de l'invention
- les figures 2a à 2d schématisent les étapes d'un procédé d'obtention du transducteur de la figure 1,
- la figure 3 est une coupe transversale d'un transducteur selon un deuxième mode de mise en oeuvre de l'invention, et
- les figures 4a à 4d schématisent les étapes d'un procédé d'obtention du transducteur de la figure 3.

### Description d'un mode de réalisation de l'invention

Comme dit précédemment, l'invention concerne un transducteur à ondes de volume guidées perfectionné par rapport au transducteur décrit dans D1 pour en simplifier la connexion électrique.

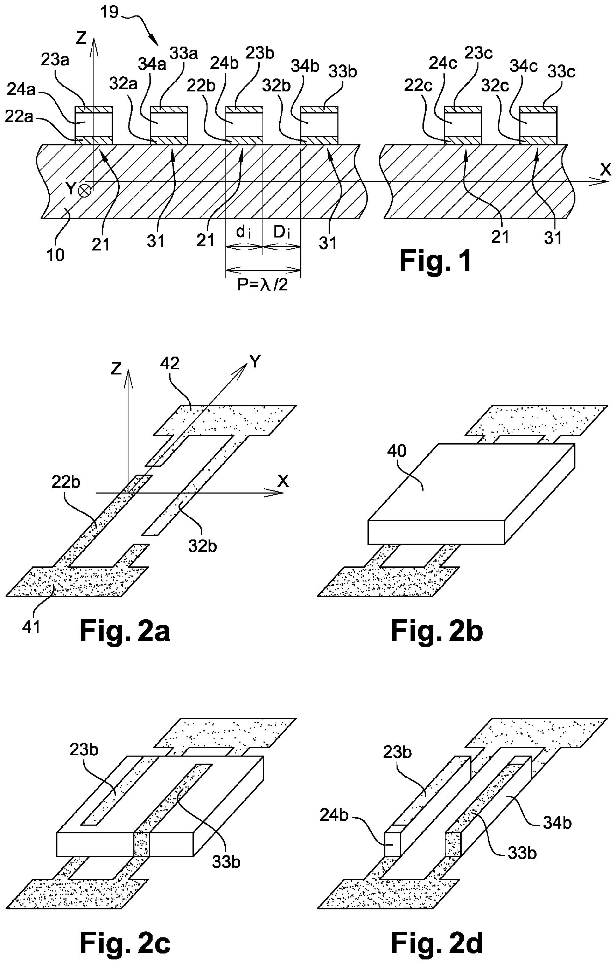

La figure 1 présente un premier mode de réalisation d'un transducteur selon l'invention, mis en oeuvre par un procédé comprenant les étapes suivantes.

Dans une première étape, une plaque de substrat 10 acoustique d'épaisseur e1 est réalisée dans un matériau électriquement isolant. Le matériau, la forme, les dimensions et l'état de surface de la plaque de substrat sont conformes à l'enseignement des documents D1, D2. A titre d'exemple non limitatif, le substrat peut être réalisé en quartz, silicium, saphir, ...,

Est ensuite réalisé sur le substrat 10 un réseau 19 de transducteurs élémentaires, réseau comprenant un premier peigne 20 et un deuxième peigne 30 de transducteurs élémentaires 21, 31. Sur la figure 1, sont représentés en coupe 3 transducteurs de chaque peigne, inter-digités, réalisés sur le substrat 10, et en particulier le premier et le dernier peignes de chaque série. Sur les figures 2a à 2d, par souci de simplification, le substrat 10 n'est pas représenté, et seuls deux transducteurs adjacents, soit un transducteur de chaque peigne, sont représentés.

Pour cela, dans une deuxième étape (fig. 2a), sont déposées sur le substrat une première série 22 d'électrodes inférieures 22a, 22b, ..., 22c et une deuxième série 32 d'électrodes inférieures 32a, 32b, ..., 32c réalisées en matériau électriquement conducteur, inter-digitées et rangées selon une direction de propagation X ; chaque électrode inférieure s'étend selon un axe transversal Y perpendiculaire à la direction de propagation X ; toutes les électrodes inférieures sont distinctes les unes des autres ; les électrodes de la première série d'électrodes inférieures sont reliées électriquement entre elles par un premier conducteur 41 et les électrodes de la deuxième série d'électrodes inférieures sont reliées électriquement entre elles par un deuxième conducteur 42.

Dans un exemple de réalisation pratique, les électrodes inférieures 22, 22a, 22b, ..., 2, 22c, 32, 32a, 32b, ..., 32c et les conducteurs de liaison 41, 42 associés sont réalisés simultanément par 1. un masquage approprié de la face supérieure du substrat puis 2. un dépôt d'une couche de matériau électriquement conducteur d'épaisseur e2 bien inférieure à l'épaisseur e1 du substrat. Le matériau choisi pour les électrodes et les conducteurs, la forme et les dimensions des électrodes sont fonction de la longueur d'onde acoustique et de la fréquence de travail souhaitées pour le transducteur et sont conformes en cela à l'enseignement des documents D1, D2.

Le matériau choisi est conducteur électrique et perméable aux ondes élastiques. Dans un exemple concret, non limitatif, les électrodes sont réalisées en un matériau métallique tel que l'Aluminium ou le Platine ou un alliage métallique tel qu'un alliage Aluminium-Cuivre ; elles ont une épaisseur e2, une largeur di et une distance Di est laissée entre les électrodes de sorte que la période P de répétition du réseau de transducteurs élémentaires est donnée par P = di + Di.

Dans une troisième étape (fig.2b), la première série d'électrodes inférieures et la deuxième série d'électrodes inférieures sont recouvertes d'une couche 40 d'un matériau piézoélectrique d'épaisseur e3, bien supérieure à l'épaisseur e2 des électrodes. La largeur de la couche piézoélectrique est sensiblement égale à la longueur d'une électrode de dessous et la longueur de la couche piézoélectrique est sensiblement égale à la distance entre la première électrode 22a de la première série et la dernière électrode 32c de la deuxième série. A titre d'exemple non limitatif, le matériau piézoélectrique peut-être du Nitrure d'Aluminium (AlN) ou de l'oxyde de zinc (ZnO). D'autres exemples de matériau sont donnés dans les documents D1, D2.

Dans une quatrième étape (fig. 2c) sont déposées, sur la couche piézoélectrique 40, une première série 23 d'électrodes supérieures 23a, 23b, ..., 23c et une deuxième série 33 d'électrodes supérieures 33a, 33b, ..., 33c réalisées en un matériau électriquement conducteur, inter-digitées et rangées selon la direction de propagation X ; chaque électrode de la première série et de la deuxième série d'électrodes supérieures s'étend selon l'axe transversal Y ; les électrodes 23a, 23b, ..., 23c de la première série d'électrodes supérieures 23 sont reliées électriquement entre elles et aux électrodes 32a, 32b, ..., 32c de la deuxième série d'électrodes inférieures 32 et les électrodes 33a, 33b, ..., 33c de la deuxième série d'électrodes supérieures 33 sont reliées électriquement entre elles et aux électrodes 22a, 22b, ..., 22c de la première série d'électrodes inférieures 22 ; les électrodes de la première 23 (respectivement la deuxième 33) série d'électrodes supérieures sont positionnées au dessus des électrodes de la première 22 (respectivement la deuxième 32) série d'électrodes inférieures.

Dans un exemple de réalisation pratique, les électrodes supérieures 26, 27 sont réalisées et les conducteurs de liaison 23, 24 associés sont prolongés simultanément par 1. un masquage approprié de la face supérieure de la couche piézoélectrique puis 2. un dépôt d'une couche de matériau électriquement conducteur d'épaisseur e4 sensiblement égale à l'épaisseur e2 des électrodes inférieures. Plus précisément, les conducteurs 23, 24 sont prolongés sur les faces latérales de part et d'autre de la couche piézoélectrique, de sorte à relier électriquement les électrodes de la deuxième série d'électrodes supérieures aux électrodes de la première série d'électrodes inférieures, d'une part, et à relier électriquement les électrodes de la première série d'électrodes supérieures aux électrodes de la deuxième série d'électrodes inférieures. Le matériau utilisé ici est par exemple le même que celui utilisé pour la réalisation des électrodes inférieures.

Enfin, dans une cinquième étape (fig. 2d), la couche de matériau piézoélectrique est gravée, par enlèvement du matériau piézoélectrique situé entre les électrodes supérieures, pour former un barreau de matériau piézoélectrique sous chaque électrode supérieure. Le gravage est réalisé sur toute l'épaisseur du matériau piézoélectrique, de préférence y compris entre les électrodes inférieures.

On obtient ainsi un transducteur comprenant, sur le substrat 10, un réseau de sources d'excitation acoustique synchrones, réseau comportant un premier peigne 20 et un deuxième peigne 30 comprenant chacun une pluralité de transducteurs élémentaires 21, 31 ; les transducteurs élémentaires du premier et du deuxième peigne sont inter-digités et rangés selon la direction X de propagation des ondes volumétriques guidées ; les transducteur élémentaires s'étendent chacun selon l'axe transversal Y ; chaque transducteur élémentaire 21, 31 comprend une électrode inférieure 22a, 32a conductrice positionnée sur le substrat, un barreau 24a, 34a en matériau piézoélectrique positionné sur l'électrode inférieure et une électrode supérieure 23a, 33a conductrice positionnée sur le barreau. Dans ce mode de réalisation, les transducteurs élémentaires du premier peigne sont connectés tête-bêche en alternance avec les transducteurs élémentaire du deuxième peigne en ce sens que l'électrode inférieure d'un transducteur élémentaire est reliée électriquement à l'électrode supérieure du transducteur précédent et à l'électrode supérieure du transducteur suivant, et l'électrode supérieure d'un transducteur est reliée électriquement à l'électrode inférieure d'un transducteur précédent et à l'électrode inférieure d'un transducteur suivant.

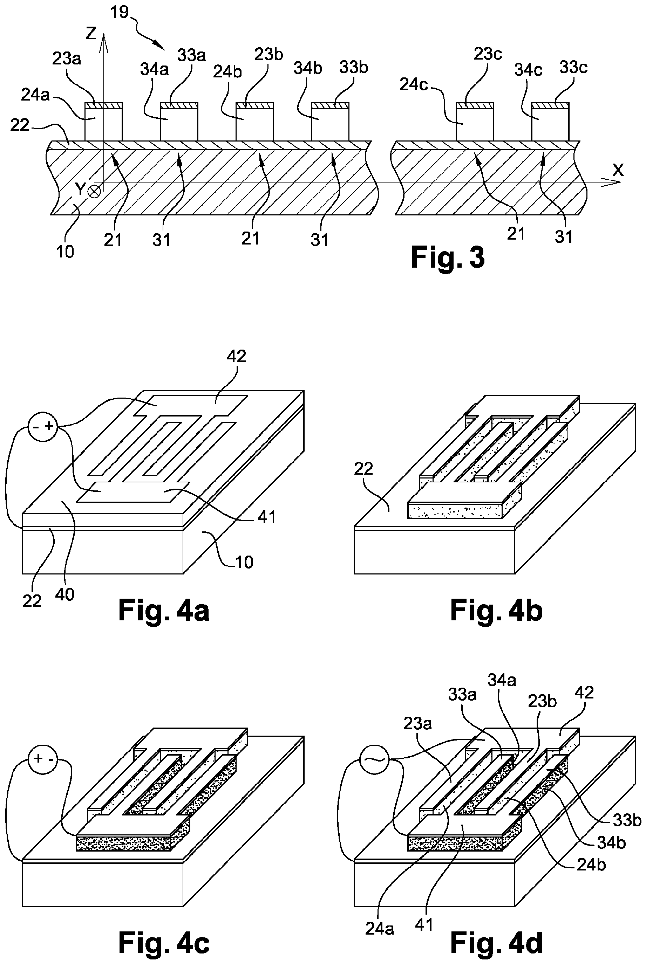

La figure 3 présente un deuxième mode de réalisation d'un transducteur selon l'invention, mis en oeuvre par un procédé comprenant les étapes suivantes. Les matériaux utilisés, les formes et les dimensions des différents éléments sont choisis comme dans l'exemple précédent. Pour réaliser la couche piézoélectrique, le matériau utilisé peut être avantageusement choisi parmi les matériaux polaires ferroélectriques tels que le niobate de lithium (LiNb0₃), le tantalate de lithium (LiTaO₃), le niobate de potassium (KNb03) ou encore les céramiques de type PZT ou relaxeurs.

Sur la figure 3, comme dans le cas de la figure 1, sont représentés en coupe 3 transducteurs de chaque peigne, inter-digités, réalisés sur le substrat 10, et en particulier le premier et le dernier peigne de chaque série. Sur les figures 4a à 4d, par souci de simplification, seuls quatre transducteurs adjacents, soit deux transducteurs de chaque peigne, sont représentés.

Dans une première étape, la plaque de substrat 10 acoustique d'épaisseur e1 est réalisée en matériau électriquement isolant. Est ensuite réalisé sur le substrat 10 le réseau 19 de transducteurs élémentaires, réseau comprenant un premier peigne 20 et un deuxième peigne 30 de transducteurs élémentaires 21, 31.

Pour cela, dans une deuxième étape sont déposées sur le substrat une première 22 et une deuxième 32 série d'électrodes inférieures 22a, 22b, ..., 22c, 32a, 32b, ..., 32c reliées entre elles ou, comme dans le cas représenté fig. 3-4, une couche 22 de matériau électriquement conducteur formant une électrode inférieure commune.

Dans une troisième étape, la ou les électrodes inférieures sont recouvertes d'une couche 40 d'un matériau piézoélectrique. Dans une quatrième étape, sur le matériau piézoélectrique, sont déposées une première série 23 d'électrodes supérieures 23a, 23b, ..., 23c et une deuxième série 33 d'électrodes supérieures 33a, 33b, ..., 33c réalisées en un matériau électriquement conducteur, inter-digitées et rangées selon la direction de propagation X, chaque électrode de la première série et de la deuxième série d'électrodes supérieures s'étendant selon l'axe transversal Y, les électrodes de la première série d'électrodes supérieures étant reliées électriquement entre elles et les électrodes de la deuxième série d'électrodes supérieures étant reliées électriquement entre elles, dans l'exemple représenté via les conducteurs 41, 42.

Dans une cinquième étape (fig. 4a), la couche 40 de matériau piézoélectrique est polarisée ; cette étape de polarisation est réalisée par exemple en appliquant un même potentiel d'excitation +V sur les conducteurs 41, 42 et les électrodes de la première et de la deuxième séries d'électrodes supérieures, toutes les électrodes inférieures ou l'électrode inférieure commune étant reliée à une masse de la source d'alimentation produisant le potentiel +V (ou l'inverse). Cette polarisation s'applique particulièrement bien aux matériaux polaires ferroélectriques tels que ceux énoncés plus haut. Il faut alors, pour forcer la polarisation locale du matériau, dépasser le champ coercitif propre au matériau en question en appliquant une différence de potentiel entre les électrodes supérieures et inférieures adéquate. A titre d'exemple, le champ coercitif du niobate de lithium et du tantalate de lithium congruents (couramment disponibles dans le commerce en plaques de 100 mm de diamètre) est de l'ordre de 21 kV/mm.

Dans une sixième étape (fig. 4b), la couche de matériau piézoélectrique est gravée, par enlèvement du matériau piézoélectrique situé entre les électrodes supérieures, pour former un barreau 24a, 24b, ..., 24c, 34a, 34b, ..., 34c de matériau piézoélectrique sous chaque électrode supérieure.

Dans une septième étape (fig. 4c) enfin, les barreaux de matériau piézoélectrique positionnés sous les électrodes de la première série d'électrodes supérieure (ou de la deuxième série d'électrodes supérieures) sont polarisés en inverse ; ainsi seul un barreau sur deux est polarisé en inverse ; cette étape de polarisation est réalisée en fonction de la polarisation réalisée lors de l'étape 5, par exemple en appliquant le potentiel d'excitation +V sur les électrodes inférieures (ou l'électrode inférieure commune 22 dans l'exemple représenté), les électrodes de la première série d'électrodes supérieures étant reliées via le conducteur 42 à la masse de la source d'alimentation référencée produisant le potentiel d'excitation +V.

Le transducteur obtenu selon ce deuxième procédé comprend, comme le précédent, une plaque de substrat 10 acoustique en matériau électriquement isolant et un réseau de sources d'excitation acoustique synchrones ; le réseau comporte un premier peigne 20 et un deuxième peigne 30 comprenant chacun une pluralité de transducteurs élémentaires 21, 31 ; les transducteurs élémentaires du premier et du deuxième peignes sont inter-digités et rangés selon une direction (X) de propagation des ondes de volume guidées ; les transducteurs élémentaires s'étendent chacun selon l'axe transversal (Y). Chaque transducteur élémentaire comprend une électrode inférieure conductrice positionnée sur le substrat (ou une électrode commune à tous les transducteurs), un barreau en matériau piézoélectrique positionné sur l'électrode inférieure et une électrode supérieure conductrice positionnée sur le barreau.

Le transducteur obtenu selon le deuxième procédé se distingue de celui obtenu par le premier procédé en ce que:
- les électrodes inférieures 22, 32 de tous les transducteurs élémentaires (première et deuxième séries) sont agencées pour être connectées ensemble à une première borne d'une source d'alimentation, ou, plus particulièrement dans l'exemple des figures 3 et 4, les électrodes inférieures sont formées d'une couche conductrice formant une électrode commune à tous les transducteurs élémentaires, couche commune agencée pour être connectée à la première borne de la source d'alimentation (la masse comme dans l'exemple de la fig. 4d, ou l'inverse),
- les électrodes supérieures 23, 33 (première et deuxième série) de tous les transducteurs élémentaires sont agencées pour être connectées ensemble à une deuxième borne de la source d'alimentation (la borne de potentiel comme dans l'exemple de la figure 4d, ou l'inverse), et
- le barreau 24a, 24b, ..., 24c de chaque transducteur du premier peigne a une polarité opposée à la polarisation du barreau 34a, 34b, ..., 34c de chaque transducteur du deuxième peigne.

Ainsi, dans ce mode de réalisation, la ou les électrodes inférieures peuvent être alimentées avec un potentiel de masse, et les électrodes supérieures de tous les transducteurs élémentaires peuvent être alimentées par la même borne d'alimentation (+V) de la source de tension (cf fig. 4d), ou l'inverse. La polarité alternée des barreaux de matériau isolant permet de retrouver l'équivalent électrique d'une alimentation alternée des transducteurs.

### Nomenclature

- X: direction de propagation
- Y: axe transversal à la direction de propagation
- Z: axe perpendiculaire à X, Y
- 10: plaque substrat
- e1: épaisseur de la plaque de substrat
- 19: réseau de transducteurs élémentaires
- 20: premier peigne de transducteurs élémentaires
- 21: transducteurs élémentaires du premier peigne
- 22: première série d'électrodes inférieures
- 22a, 22b, 22c: électrodes inférieures
- 23: première série d'électrodes supérieures
- 23a, 23b, 23c: électrodes supérieures
- 24a, 24b, 24c: pluralité de barreaux piézoélectriques
- 30: deuxième peigne de transducteurs élémentaires
- 31: transducteurs élémentaires du deuxième peigne
- 32: deuxième série d'électrodes inférieures
- 32a, 32b, 32c: électrodes inférieures
- 33: deuxième série d'électrodes supérieures
- 33a, 33b, 33c: électrodes supérieures
- 34a, 34b, 34c: pluralité de barreaux piézoélectriques
- 40: couche piézoélectrique
- 41: premier conducteur
- 42: deuxième conducteur

## Revendications

1. Transducteur à ondes de volume guidées, comprenant une plaque de substrat (10) acoustique en matériau électriquement isolant et un réseau de sources d'excitation acoustique synchrones, le réseau comportant un premier peigne (20) et un deuxième peigne (30) comprenant chacun une pluralité de transducteurs élémentaires (21 ; 31), les transducteurs élémentaires du premier et du deuxième peigne étant inter-digités et rangés selon une direction (X) de propagation des ondes de volume guidées, les transducteurs élémentaires s'étendant chacun selon un axe transversal (Y) perpendiculaire à la direction de propagation,
transducteur **caractérisé en ce que** chaque transducteur élémentaire comprend une électrode inférieure (22a, 22b, ... 22c ; 32a, 32b, ..., 32c) conductrice positionnée sur le substrat, l'électrode inférieure d'un transducteur élémentaire étant distincte de l'électrode inférieure des transducteurs élémentaires adjacents, un barreau en matériau piézoélectrique (24a, 24b, ..., 24c ; 34a, 34b, ..., 34c) positionné sur l'électrode inférieure et une électrode supérieure conductrice (23a, 23b, ..., 23c ; 33a, 33b, ..., 33c) positionnée sur le barreau, l'électrode supérieure d'un transducteur élémentaire étant distincte de l'électrode supérieure des transducteurs élémentaires adjacents.

2. Transducteur selon la revendication 1 dans lequel une électrode (22b ou 23b) d'un transducteur élémentaire est reliée électriquement à une borne d'alimentation d'une source électrique d'excitation référencée et l'autre électrode (23b ou 22b) du même transducteur élémentaire est reliée à une masse électrique de la dite source.

3. Transducteur selon l'une des revendications 1 à 2 dans lequel l'électrode inférieure (32a ; 22b) d'un transducteur élémentaire est reliée électriquement à l'électrode supérieure (23a ; 33a) du transducteur élémentaire précédent et à l'électrode supérieure (23b ; 33b) du transducteur élémentaire suivant et dans lequel l'électrode supérieure (33a ; 23b) d'un transducteur élémentaire est reliée électriquement à l'électrode inférieure (22a ; 32a) du transducteur élémentaire précédent et à l'électrode inférieure (22b ; 32b) du transducteur élémentaire suivant.

4. Transducteur selon la revendication 1 à 2 dans lequel les électrodes inférieures (22a, 22b, ..., 22c ; 32a, 32b, ..., 32c) de tous les transducteurs élémentaires (21, 31) sont agencées pour être connectées ensemble à une première borne d'une source d'alimentation, dans lequel les électrodes supérieures (23a, 23b, ..., 23c ; 33a, 33b, ..., 33c) de tous les transducteurs élémentaires (21, 31) sont agencées pour être connectées ensemble à une deuxième borne de la source d'alimentation, la première borne et la deuxième borne étant respectivement une borne de potentiel et une masse ou l'inverse, et dans lequel le barreau (24a, 24b, ...24c) de chaque transducteur élémentaire (21) du premier peigne a une polarisation opposée à la polarisation du barreau (34a, 34b, ..., 34c) de chaque transducteur élémentaire (31) du deuxième peigne.

5. Transducteur selon la revendication 4 dans lequel le substrat est recouvert d'une couche conductrice formant une électrode commune électriquement équivalente à l'ensemble des électrodes inférieures de tous les transducteurs élémentaires, les barreaux polarisés (24a, 34a, 24b, 34b, ..., 24c, 34c) étant positionnés sur la couche conductrice formant électrode inférieure commune.

6. Procédé de réalisation d'un transducteur selon l'une des revendications 1 à 3 comprenant les étapes suivantes consistant à :
• réaliser une plaque de substrat (10) acoustique en matériau électriquement isolant,
• déposer sur le substrat une première série (22) d'électrodes inférieures (22a, 22b, ..., 22c) et une deuxième série (32) d'électrodes inférieures (32a, 32b, ..., 32c) réalisées en matériau électriquement conducteur, inter-digitées et rangées selon une direction de propagation (X) des ondes de volume guidées, chaque électrode inférieure (22a, 32a, 22b, 32b, ..., 22c, 32c) s'étendant selon un axe transversal (Y) perpendiculaire à la direction de propagation (X), les électrodes (22a, 22b, ..., 22c) de la première série d'électrodes inférieures étant reliées électriquement entre elles et les électrodes (32a, 32b, ..., 32c) de la deuxième série d'électrodes inférieures étant reliées électriquement entre elles,
• recouvrir d'une couche (40) d'un matériau piézoélectrique la première série d'électrodes inférieures et la deuxième série d'électrodes inférieures,
• déposer sur le matériau piézoélectrique une première série (23) d'électrodes supérieures (23a, 23b, ..., 23c) et une deuxième série (33) d'électrodes supérieures (33a, 33b, ..., 33c) réalisées en matériau électriquement conducteur, inter-digitées et rangées selon la direction de propagation (X), chaque électrode supérieure (23a, 33a, 23b, 33b, ..., 23c, 33c) s'étendant selon l'axe transversal (Y), les électrodes (23a, 23b, ..., 23c) de la premières série d'électrodes supérieures étant reliées électriquement entre elles et aux électrodes (32a, 32b, ..., 32c) de la deuxième série d'électrodes inférieures et les électrodes (33a, 33b, ..., 33c) de la deuxième série d'électrodes supérieures étant reliées électriquement entre elles et aux électrodes (22a, 22b, ..., 22c) de la première série d'électrodes inférieures,
• graver la couche de matériau piézoélectrique, par enlèvement du matériau piézoélectrique situé entre les électrodes supérieures pour former un barreau de matériau piézoélectrique sous chaque électrode supérieure.

7. Procédé de réalisation d'un transducteur selon l'une des revendications 1, 2, ou 5, procédé comprenant les étapes suivantes consistant à :
• réaliser une plaque de substrat (10) acoustique en matériau électriquement isolant,
• déposer sur le substrat, soit une première série (22) d'électrodes inférieures (22a, 22b, ..., 22c) et une deuxième série (32) d'électrodes inférieures (32a, 32b, ..., 32c) en matériau électriquement conducteur, chaque électrode inférieure (22a, 32a, 22b, 32b, ..., 22c, 32c) s'étendant selon un axe transversal (Y), les électrodes de la première série et de la deuxième série d'électrodes inférieures étant interdigitées et rangées selon une direction de propagation (X) des ondes de volume guidées perpendiculaire à un axe transversal (Y), les électrodes (22a, 22b, ..., 22c) de la première série d'électrodes inférieures et les électrodes (32a, 32b, ..., 32c) de la deuxième série d'électrodes inférieures étant reliées électriquement entre elles, ou soit une couche (43) de matériau électriquement conducteur formant une électrode inférieure commune,
• recouvrir d'une couche (40) d'un matériau piézoélectrique la ou les électrodes inférieures (43 ; 22a, 32a, 22b, 32b, ..., 22c, 32c),
• déposer sur la couche (40) de matériau piézoélectrique une première série (23) d'électrodes supérieures (23a, 23b, ..., 23c) et une deuxième série (33) d'électrodes supérieures (33a, 33b, ..., 33c) réalisées en un matériau électriquement conducteur, interdigitées et rangées selon la direction de propagation, chaque électrode de la première série et de la deuxième série d'électrodes supérieures s'étendant selon l'axe transversal, les électrodes de la premières série d'électrodes supérieure étant reliées électriquement entre elles et les électrodes de la deuxième série d'électrodes supérieure étant reliées électriquement entre elles,
• polariser la couche de matériau piézoélectrique (40)
• graver la couche de matériau piézoélectrique, par enlèvement du matériau piézoélectrique situé entre les électrodes supérieures pour former un barreau (24a, 34a, 24b, 34b, ...24c, 34c) de matériau piézoélectrique sous chaque électrode supérieure,
• polariser en inverse les barreaux (24a, 24b, ... 24c) de matériau piézoélectrique positionnés sous les électrodes de la première série d'électrodes supérieure.

8. Transducteur selon l'une des revendications 1 à 5 dans lequel le matériau piézoélectrique présente des propriétés ferroélectriques.

9. Dispositif comprenant un transducteur selon l'une des revendications 1 à 5 ou 8, connecté à une antenne radio-fréquence adaptée pour exciter et / ou détecter les ondes élastiques émises et / ou reçues par le transducteur sans fil.

10. Filtre de fréquences à entrée / sortie différentielles, comprenant un transducteur selon l'une des revendications 1 à 5, 8 ou 9.

## Patentansprüche

1. Wandler mit geführten Volumenwellen mit einer akustischen Substratplatte (10) aus elektrisch isolierendem Material und einer Anordnung synchroner akustischer Erregungsquellen, wobei die Anordnung einen ersten Kamm (20) und einen zweiten Kamm (30) umfasst, die jeweils mehrere Elementarwandler (21; 31) umfassen, wobei die Elementarwandler des ersten und des zweiten Kamms interdigital und in einer Ausbreitungsrichtung (X) der geführten Volumenwellen angeordnet sind, wobei sich die Elementarwandler jeweils entlang einer Querachse (Y) erstrecken, die senkrecht zur Ausbreitungsrichtung ist,
Wandler, **dadurch gekennzeichnet, dass** jeder Elementarwandler eine leitfähige untere Elektrode (22a, 22b, ..., 22c; 32a, 32b, ..., 32c) umfasst, die auf dem Substrat angeordnet ist, wobei die untere Elektrode eines Elementarwandlers von der unteren Elektrode der benachbarten Elementarwandler getrennt ist, ein Stab aus piezoelektrischem Material (24a, 24b, ..., 24c, 34a, 34b, ..., 34c), der auf der unteren Elektrode angeordnet ist, und eine leitfähige obere Elektrode (23a, 23b, ..., 23c; 33b, ..., 33c), die auf dem Stab angeordnet sind, wobei die obere Elektrode eines Elementarwandlers von der oberen Elektrode der benachbarten Elementarwandler getrennt ist.

2. Wandler nach Anspruch 1, bei dem eine Elektrode (22b oder 23b) eines Elementarwandlers elektrisch mit einem Stromversorgungsanschluss einer referenzierten elektrischen Erregungsquelle und die andere Elektrode (23b oder 22b) des gleichen Elementarwandlers mit einer elektrischen Masse dieser Quelle verbunden ist.

3. Wandler nach einem der Ansprüche 1 bis 2, bei dem die untere Elektrode (32a; 22b) eines Elementarwandlers elektrisch mit der oberen Elektrode (23a; 33a) des vorhergehenden Elementarwandlers und mit der oberen Elektrode (23b; 33b) des nächsten Elementarwandlers verbunden ist und wobei die obere Elektrode (33a; 23b) eines Elementarwandlers elektrisch mit der unteren Elektrode (22a; 32a) des vorhergehenden Elementarwandlers und mit der unteren Elektrode (22b; 32b) des nächsten Elementarwandlers verbunden ist.

4. Wandler nach Anspruch 1 bis 2, bei dem die unteren Elektroden (22a, 22b, ..., 22c; 32a, 32b, ..., 32c) aller Elementarwandler (21, 31) so angeordnet sind, dass sie zusammen mit einem ersten Anschluss einer Stromquelle verbunden sind, wobei die oberen Elektroden (23a, 23b, ..., 23c; 33a, 33b, ..., 33c) aller Elementarwandler (21, 31) so angeordnet sind, dass sie zusammen mit einem zweiten Anschluss der Stromquelle verbunden sind, wobei der erste Anschluss und der zweite Anschluss jeweils ein Potentialanschluss und eine Masse oder umgekehrt sind, und wobei der Stab (24a, 24b, ..., 24c) jedes Elementarwandlers (21) des ersten Kamms eine Polarisation aufweist , die der Polarisation des Stabes (34a, 34b, ..., 34c) jedes Elementarwandlers (31) des zweiten Kamms entgegengesetzt ist.

5. Wandler nach Anspruch 4, bei dem das Substrat mit einer leitfähigen Schicht bedeckt ist, die eine gemeinsame Elektrode bildet, die elektrisch der Gesamtheit der unteren Elektroden aller Elementarwandler entspricht, wobei die polarisierten Stäben (24a, 34a, 24b, 34b, ..., 24c) 34c) auf der Leitschicht angeordnet sind, die die gemeinsame unteren Elektrode bildet.

6. Verfahren zur Herstellung eines Wandlers nach einem der Ansprüche 1 bis 3, das die folgenden Schritte umfasst:
• Herstellen einer akustischen Substratplatte (10) aus elektrisch isolierendem Material,
• Aufbringen auf dem Substrat einer ersten Reihe (22) von unteren Elektroden (22a, 22b, ..., 22c) und einer zweiten Reihe (32) von unteren Elektroden (32a, 32b, ..., 32c) aus elektrisch leitfähigem Material, die interdigital und in einer Ausbreitungsrichtung (X) der geführten Volumenwellen angeordnet sind, wobei sich jede untere Elektrode (22a, 32a, 22b, 32b, ..., 22c, 32c) entlang einer Querachse (Y) erstreckt, die senkrecht zur Ausbreitungsrichtung (X) ist, wobei die Elektroden (22a, 22b, ..., 22c) der ersten Reihe von unteren Elektroden elektrisch miteinander verbunden sind und die Elektroden (32a, 32b, ..., 32c) der zweiten Reihe von unteren Elektroden elektrisch miteinander verbunden sind,
• Bedecken der ersten Reihe von unteren Elektroden und der zweiten Reihe von unteren Elektroden mit einer Schicht (40) aus einem piezoelektrischen Material,
• Aufbringen auf dem piezoelektrischen Material einer ersten Reihe (23) von oberen Elektroden (23a, 23b, ..., 23c) und einer zweiten Reihe (33) von oberen Elektroden (33a, 33b, ..., 33c) aus elektrisch leitfähigem Material, die interdigital und in Ausbreitungsrichtung (X) angeordnet sind, wobei sich jede obere Elektrode (23a, 33a, 23b, 33b, ..., 23c, 33c) entlang der Querachse (Y) erstreckt, wobei die Elektroden (23a, 23b), ..., 23c) der ersten Reihe von oberen Elektroden elektrisch miteinander und mit den Elektroden (32a, 32b, ..., 32c) der zweiten Reihe von unteren Elektroden verbunden sind und die Elektroden (33a, 33b, ..., 33c) der zweiten Reihe von oberen Elektroden elektrisch miteinander und mit den Elektroden (22a, 22b, ..., 22c) der ersten Reihe von unteren Elektroden verbunden sind,
• Ätzen der Schicht aus piezoelektrischem Material durch Entfernen des piezoelektrischen Materials zwischen den oberen Elektroden, um einen Stab aus piezoelektrischem Material unter jeder oberen Elektrode zu bilden.

7. Verfahren zur Herstellung eines Wandlers nach einem der Ansprüche 1, 2 oder 5, wobei das Verfahren die folgenden Schritte umfasst:
• Herstellen einer akustischen Substratplatte (10) aus elektrisch isolierendem Material,
• entweder Aufbringen einer ersten Reihe (22) von unteren Elektroden (22a, 22b, ..., 22c) und einer zweiten Reihe (32) von unteren Elektroden (32a, 32b, ..., 32c) aus elektrisch leitfähigem Material auf dem Substrat, wobei sich jede untere Elektrode (22a, 32a, 22b, 32b, ..., 22c, 32c) entlang einer Querachse (Y) erstreckt, wobei die Elektroden der ersten Reihe und der zweiten Reihe von unteren Elektroden interdigital und in einer Ausbreitungsrichtung (X) der geführten Volumenwellen angeordnet sind, die senkrecht zu einer Querachse (Y) verläuft, wobei die Elektroden (22a, 22b, ..., 22c) der ersten Reihe von unteren Elektroden und die Elektroden (32a, 32b, ..., 32c) der zweiten Reihe von unteren Elektroden elektrisch miteinander verbunden sind oder Aufbringen einer Schicht (43) aus elektrisch leitfähigem Material, die eine gemeinsame untere Elektrode bildet,
• Bedecken der unteren Elektrode oder der unteren Elektroden (43; 22a, 32a, 22b, 32b, ..., 22c, 32c) mit einer Schicht (40) aus einem piezoelektrischen Material,
• Aufbringen auf einer Schicht (40) aus piezoelektrischem Material einer ersten Reihe (23) von oberen Elektroden (23a, 23b, ..., 23c) und einer zweiten Reihe (33) von oberen Elektroden (33a, 33b, 33c) aus elektrisch leitfähigem Material, welche interdigital und in Ausbreitungsrichtung angeordnet sind, wobei sich jede Elektrode der ersten Reihe und der zweiten Reihe von oberen Elektroden entlang der Querachse erstrecken, wobei die Elektroden der ersten Reihe von oberen Elektroden elektrisch miteinander verbunden sind und die Elektroden der zweiten Reihe von oberen Elektroden elektrisch miteinander verbunden sind.
• Polarisieren der Schicht aus piezoelektrischem Material (40)
• Ätzen der Schicht aus piezoelektrischem Material durch Entfernen des piezoelektrischen Materials zwischen den oberen Elektroden, um einen Stab (24a, 34a, 24b, 34b, ..., 24c, 34c) aus piezoelektrischem Material unter jeder oberen Elektrode zu bilden,
• Umpolarisieren der Stäbe (24a, 24b, ..., 24c) aus piezoelektrischem Material, die unter den Elektroden der ersten Reihe von oberen Elektroden angeordnet sind.

8. Wandler nach einem der Ansprüche 1 bis 5, bei dem das piezoelektrische Material ferroelektrische Eigenschaften aufweist.

9. Vorrichtung mit einem Wandler nach einem der Ansprüche 1 bis 5 oder 8, die mit einer Hochfrequenzantenne verbunden ist, die dazu eingerichtet ist, elastische Wellen anzuregen und / oder zu detektieren, die von dem drahtlosen Wandler gesendet und / oder empfangen werden.

10. Differenzialer Eingangs- / Ausgangsfrequenzfilter mit einem Wandler nach einem der Ansprüche 1 bis 5, 8 oder 9.

## Claims

1. A guided volume wave transducer, comprising an acoustic substrate plate (10) made of an electrically insulating material and an array of synchronous acoustic excitation sources, the array including a first comb (20) and a second comb (30), each of which comprises a plurality of elementary transducers (21; 31), the elementary transducers of the first comb and of the second comb being interdigitated and arranged along a propagation direction (X) along which the guided volume waves propagate, each of the elementary transducers extending along a transverse axis (Y) that is perpendicular to the propagation direction;
said guided volume wave transducer being **characterized in that** each elementary transducer comprises a lower conductive electrode (22a, 22b, ..., 22c ; 32a, 32b, ..., 32c) positioned on the substrate, the lower electrode of any one elementary transducer being distinct from the lower electrodes of the adjacent elementary transducers, a bar made of a piezoelectric material (24a, 24b, ..., 24c ; 34a, 34b, ..., 34c) and positioned on the lower electrode, and an upper conductive electrode (23a, 23b, ..., 23c; 33a, 33b, ..., 33c) positioned on the bar, the upper electrode of any one elementary transducer being distinct from the upper electrodes of the adjacent elementary transducers.

2. A transducer according to claim 1, wherein an electrode (22b or 23b) of an elementary transducer is connected electrically to a power terminal of a referenced excitation electrical source and the other electrode (23b or 22b) of the same elementary transducer is connected to an electrical ground terminal of said source.

3. A transducer according to claim 1 or claim 2, wherein the lower electrode (32a, 22b) of an elementary transducer is connected electrically to the upper electrode (23a ; 33a) of the preceding elementary transducer and to the upper electrode (23b ; 33b) of the following elementary transducer, and wherein the upper electrode (33a ; 23b) of an elementary transducer is connected electrically to the lower electrode (22a; 32a) of the preceding elementary transducer and to the lower electrode (22b; 32b) of the following elementary transducer.

4. A transducer according to claim 1 or claim 2, wherein the lower electrodes (22a, 22b, ..., 22c ; 32a, 32b, ..., 32c) of all of the elementary transducers (21, 31) are arranged to be connected together to a first terminal of a power source, wherein the upper electrodes (23a, 23b, ..., 23c ; 33a, 33b, ..., 33c) of all of the elementary transducers (21, 31) are arranged to be connected together to a second terminal of the power source, the first terminal and the second terminal being respectively a potential terminal and a ground terminal or *vice versa*, and wherein the bar (24a, 24b, ..., 24c) of each elementary transducer (21) of the first comb has a polarization that is the opposite of the polarization of the bar (34a, 24b, ..., 34c) of each elementary transducer (31) of the second comb.

5. A transducer according to claim 4, wherein the substrate is covered with a conductive layer forming a common electrode electrically equivalent to all of the lower electrodes of all of the elementary transducers, the polarized bars (24a, 34a, 24b, 34b, ..., 24c, 34c) being positioned on the conductive layer forming the common lower electrode.

6. A method of forming a transducer according to any one of claims 1 to 3, comprising the following steps consisting in:
• forming an acoustic substrate plate (10) made of an electrically insulating material;
• depositing on the substrate a first series (22) of lower electrodes (22a, 22b, ..., 22c) and a second series (32) of lower electrodes (32a, 32b, ..., 32c) made of an electrically conductive material, interdigitated and arranged along a propagation direction (X) along which the guided volume waves propagate, each lower electrode (22a, 32a, 22b, 32b, ..., 22c, 32c) extending along a transverse axis (Y) perpendicular to the propagation direction (X), the electrodes (22a, 22b ..., 22c) of the first series of lower electrodes being electrically connected together, and the electrodes (32a, 32b, ..., 32c) of the second series of lower electrodes being electrically connected together;
• covering the first series of lower electrodes and the second series of lower electrodes with a layer (40) of a piezoelectric material;
• depositing on the piezoelectric material a first series (23) of upper electrodes (23a, 23b, ..., 23c) and a second series (33) of upper electrodes (33a, 33b, ..., 33c) made of an electrically conductive material, interdigitated and arranged along a propagation direction (X), each upper electrode (23a, 33a, 23b, 33b, ..., 23c, 33c) extending along the transverse axis (Y), the electrodes (23a, 23b ..., 23c) of the first series of upper electrodes being electrically connected together and to the electrodes (32a, 32b, ..., 32c) of the second series of lower electrodes and the electrodes (33a, 33b, ..., 33c) of the second series of upper electrodes being electrically connected together and to the electrodes (22a, 22b, ..., 22) of the first series of lower electrodes; and
• etching the layer of piezoelectric material, by removing piezoelectric material situated between the upper electrodes to form a bar of piezoelectric material under each upper electrode.

7. A method of forming a transducer according to claim 1, claim 2, or claim 5, comprising the following steps consisting in:
• forming an acoustic substrate plate (10) made of an electrically insulating material;
• depositing on the substrate, either a first series (22) of lower electrodes (22a, 22b ..., 22c) and a second series (32) of lower electrodes (32a, 32b, ..., 32c) made of an electrically conductive material, each lower electrode (22a, 32a, 22b 32b, ..., 22c, 32c) extending along a transverse axis (Y), the electrodes of the first series and of the second series of lower electrodes being interdigitated and arranged in a propagation direction (X) along which guided volume waves propagate perpendicularly to a transverse axis (Y), the electrodes (22a, 22b ..., 22c) of the first series of lower electrodes and the electrodes (32a, 32b, ..., 32c) of the second series of lower electrodes being electrically connected together, or a layer (43) of electrically conductive material forming a common lower electrode;
• covering the lower electrode(s) (43 ; 22a, 32a, 22b, 32b, ..., 22c, 32c) with a layer (40) of a piezoelectric material;
• depositing on the layer (40) of piezoelectric material a first series (23) of upper electrodes (23a, 23b, ..., 23c) and a second series (33) of upper electrodes (33a, 33b, 33c) made of an electrically conductive material, interdigitated and arranged along the propagation direction, each electrode of the first series and of the second series of upper electrodes extending along the transverse axis, the electrodes of the first series of upper electrodes being electrically connected together and the electrodes of the second series of upper electrodes being electrically connected together;
• polarizing the layer of piezoelectric material (40);
• etching the layer of piezoelectric material, by removing piezoelectric material situated between the upper electrodes to form a bar (24a, 34a, 24b, 34b, ..., 24c, 34c) of piezoelectric material under each upper electrode;
• reversely polarize the bars (24a, 24b, ..., 24c) of piezoelectric material positioned under the electrodes of the first series of upper electrodes.

8. A transducer according to any one of claims 1 to 5, wherein the piezoelectric material has ferroelectric properties.

9. A device including a transducer according to any one of claims 1 to 5 or 8, connected to a radiofrequency antenna adapted to excite and/or detect the elastic waves transmitted and/or received by the wireless transducer.

10. A differential input/output frequency filter, including a transducer according to any one of claims 1 to 5, 8 or 9.
